(19) Europäisches Patentamt

European Patent Office

Office européen des brevets

(11) Veröffentlichungsnummer: **0 288 677 B1**

(12) **EUROPÄISCHE PATENTSCHRIFT**

(45) Veröffentlichungstag der Patentschrift: **19.08.92**

(51) Int. Cl.⁵: **B32B 7/02**, B32B 15/20, B32B 15/18, C23C 14/22, F16C 33/12, F16C 33/44, F16C 33/56, B23B 27/14

(21) Anmeldenummer: **88102555.5**

(22) Anmeldetag: **22.02.88**

Die Akte enthält technische Angaben, die nach dem Eingang der Anmeldung eingereicht wurden und die nicht in dieser Patentschrift enthalten sind.

(54) **Bauteil, insbesondere Maschinenelement.**

(30) Priorität: **30.04.87 CH 1668/87**

(43) Veröffentlichungstag der Anmeldung:
**02.11.88 Patentblatt 88/44**

(45) Bekanntmachung des Hinweises auf die Patenterteilung:
**19.08.92 Patentblatt 92/34**

(84) Benannte Vertragsstaaten:
**AT BE CH DE ES FR GB IT LI NL SE**

(56) Entgegenhaltungen:
**DE-A- 2 940 376**
**DE-A- 3 404 880**
**DE-C- 2 853 724**
**DE-C- 2 914 618**

(73) Patentinhaber: **BALZERS AKTIENGESELL-SCHAFT**

**FL-9496 Balzers(LI)**

(72) Erfinder: **Bergmann, Erich, Dr.**
**Sarganserstrasse 58**
**CH-8887 Mels(CH)**
Erfinder: **Berger, Manfred, Dipl.-Ing-**
**Haus 510**
**A-6811 Göfis(AT)**

(74) Vertreter: **Keller, René, Dr. et al**
**Patentanwälte Dr. René Keller & Partner**
**Postfach 12**
**CH-3000 Bern 7(CH)**

EP 0 288 677 B1

**Beschreibung**

Die Erfindung bezieht sich auf ein vorwiegend einer Wälzbeanspruchung ausgesetztes Bauteil, insbesondere Maschinenelement, gemäss dem Oberbegriff des Patentanspruchs 1.

Die Konstruktion und Werkstoffauswahl bei Maschinenelementen, deren Funktionsflächen im wesentlichen einer Wälzbeanspruchung ausgesetzt sind, wie die Zahnräder von Getrieben oder die Komponenten von Kugel- und Nadellagern, ist heute sehr ausgereift. Durch jahrzehntelange Optimierung von Geometrie, Werkstoffwahl, Wärmebehandlung und Fertigungstechnik sind verschleissarme Produkte entstanden, die mit vertretbarem Aufwand gefertigt werden können. Das Hauptproblem früherer Maschinenelemente, der Ermüdungsverschleiss, kann als gelöst betrachtet werden. Ein anderes Problem des Wälzkörperverschleisses konnte allerdings bisher nicht gelöst werden. In allen Wälzlagerungen oder Wälzantrieben tritt nämlich zusätzlich zur Rollbewegung auch eine Gleitbewegung auf. Diese führt zu Gleitverschleiss in gewissen Zonen der Bauteile, wie dem Bereiche von positiven und negativen Schlupf von Zahnrädern oder von Schultern der Laufbahnen und Kugellagern. Die Zonen und die dort auftretenden Beanspruchungen sind dem Konstrukteur bei allen herkömmlichen Maschinenelementen wohl bekannt, auch viele Einflussfaktoren, die diesen Mikroverschleiss, wie er auch genannt wird, beeinflussen: Innere Spannungen aus der Wärmebehandlung und der Bearbeitung, Art und Ausmass der Oberflächenrauhigkeit, Schmierverhältnisse. Ein weiteres Problem bei Wälzkörpern tritt auf, wenn das Hauptverschleissproblem durch die Wahl von zwei sehr harten Partnern gelöst wird. Deren Relativbewegung ist dann nämlich immer von zwei erheblichen, gespeicherten elastischen Verformungskräften begleitet, was bei schwacher Dämpfung zu Schwingungen führt. Diese sind als Lärm allen Benützern von Maschinen, die mit Wälzlagerungen ausgerüstet sind, vertraut. In manchen Anwendungen, Medizinaltechnik, Personenkraftwagen,etc., ist dieser Lärm störend bis untolerierbar. Eine Lösung im Rahmen des bisherigen Standes der Technik konnte aber nicht gefunden werden.

Zwar wurden schon zahlreiche Versuche, die bekannten Probleme mit Beschichtungen zu lösen, durchgeführt. Aus verschiedenen Gründen sind sie alle gescheitert. So wurden manchmal Getriebeteile und Zahnräder galvanisch oder stromlos vernickelt und verchromt. Dabei kommt es jedoch zu Wasserstoffversprödung des Grundwerkstoffes und die viel entscheidendere Resistenz gegen Ermüdungsverschleiss geht verloren. Auch mit PVD-Verfahren aufgebrachte Schichten aus Kupfer, Indium, Blei und Silber wurden erprobt. Leider verschleissten diese Schichten aus Blei, Silber, Gold und Indium bei normalen Einsatzbedingungen sehr rasch durch Tribooxidation. Im Hochvakuum werden Blei-, Silber und Gold- schichten eingesetzt, allerdings verwendet man sie nur bei sehr hochpolierten Oberflächen und in Konfigurationen mit sehr wenig Gleitbewegung. Dann reichen sehr dünne Schichten aus. Eine Lösung des Lärmproblems bringen diese Schichten jedoch nicht. Kupferschichten eignen sich auch deshalb nicht für geölte Getriebe, weil Kupferabrieb alle Oele katalytisch zersetzt.

Auch wurde bereits vorgeschlagen, reine Gleitlager nach dem PVD-Verfahren mit verschiedenen Werkstoffen zu beschichten, (DE-C-28 53 724, DE-C-29 14 618 sowie DE-A-34 04 880). Dabei wurde die PVD-Technik dazu verwendet, mit Oxideinlagerungen die Warmhärte der Lagerschichten zu verbessern. Solche Schichten sind heute bei Gleitlagern in Motoren im Einsatz (vgl. U. Engel, Development and testing of new multilayer materials for modern engine bearings, part 2 - Copper-lead- three-layer bearings with sputtered overlay, in SAE Technical Paper Series, Int. Congress and exposition, Detroit, Feb. 24 to 28 1986, Seiten 76 und 77). In der Vergangenheit hatte sich jedoch immer gezeigt, dass solche Gleitlagerwerkstoffbeschichtungen für Wälzbeanspruchungenen untauglich sind. In der Tat, während seit Jahrzehnten beinahe alle in der Technik verwendeten Gleitlager eine Beschichtung aufweisen, sind praktisch keine beschichteten Wälzkörper im Einsatz.

Der Erfindung liegt nun die Aufgabe zu Grunde, Bauteile, insbesondere Maschinenelemente, welche vorwiegend einer Wälzbeanspruchung aber auch einer Gleitbeanspruchung ausgesetzt sind, dahingehend zu verbessern, dass sie dicht nur dem Wälzverschleiss, sondern auch dem Gleitverschleiss standhalten.

Diese Aufgabe wird durch Bauteile gemäss Patentanspruch 1 gelöst. Indem auf die einer Gleitbeanspruchung ausgesetzten Funktionsflächen von Wälzelementen mindestens eine PVD-Beschichtung aus einem Gleitlager-Legierungswerkstoff aufgebracht ist, deren Dicke von derselben Grössenordnung wie die Oberflächenrauhigkeit, nämlich eine Dicke vom 0,2- bis 4-fachen der Oberflächenrauheit $R_z$ des Grundkörpers ist, wird erstmals erreicht, dass bei gleichzeitiger Wälz- und Gleitbeanspruchung der Verschleiss minimal gehalten werden kann. Die Erfindungsaufgabe kann aber, wie gesagt, nicht einfach durch eine beliebige Gleitlagerwerkstoffschichtung gelöst werden, sondern es bedarf der spezifischen Merkmale eines nach dem PVD-Verfahren abgeschiedenen Gleitlager-Legierungswerkstoffes.

Im folgenden werden unter Gleitlagerwerkstoff im Sinne der Erfindung ausschliesslich durch PVD abgeschiedene Legierungen verstanden. Die Bemessung der Gleitlagerwerkstoff-Beschichtungsdicke (Schichtstärke) vom 0,2- bis 4-fachen des $R_z$-Werts ist für eine ausreichende Tragfähigkeit der Beschichtung bzw. des beschichteten Bauteils bei der Wälzbeanspruchung von entscheidender Bedeutung. Im folgenden wird die Beschichtungsdicke vom 0,2- bis 4-fachen der Oberflächenrauheit $R_z$ kurz als "von der gleichen grössenordnung wie die Oberflächenrauhigkeit" bezeichnet.

Die Eignung von durch PVD-Verfahren aufgebrachten Gleitlagerverkstoffschichten ist sowohl an sich überraschend und auch nur dann gegeben, wenn die Schichtstärke von derselben Grössenordnung wie die Oberflächenrauhigkeit ist. Bei den erwähnten bekannten Gleitlagerbeschichtungen wurden dagegen stets Schichtstärken verwendet, die wenigstens eine Grössenordnung über der Oberflächenrauhigkeit liegen.

Dass mit einer Gleitbeanspruchung immer erhebliche Wärmeentwicklung verbunden ist, war bisher einer der Hauptgründe für den raschen Verschleiss der Wälzkörperfunktionsflächen. Mit der dadurch verursachten Temperaturerhöhung war vermutlich ein lokaler Verlust der mechanischen Eigenschaften z.B. infolge Uebersteigens von Anlasstemperaturen verbunden. Wenn jedoch die eingelagerte Komponente des Gleitlagerverkstoffes einen Schmelspunkt aufweist, der unter einer solchen kritischen Temperatur z.B. der Anlasstemperatur des Werkstoffes, aus dem der Bauteil oder dessen oberflächengehärtete Randzone liegt, besteht, kann die erwähnte Verschlechterung der mechanischen Eigenschaften vermieden werden. Z.B. können als eingelagerte Gleitwerkstoffe Blei (Schmelzpunkt 327.4° C), Zinn (Schmelzpunkt 231,89° C) oder Indium (Schmelzpunkt 156,4° C) bzw. Legierungen derselben verwendet werden. Als Matrix hiefür haben sich Aluminium und Kupferlegierungen bewährt.

Es ist bekannt, dass bei mehrphasigen Gleitlagerverkstoffschichten die Feinheit der Verteilung die mechanischen Eigenschaften der Schicht, insbesondere ihre Härte wesentlich beeinflusst. In besonderer Ausgestaltung der Erfindung wählt man daher für bestimmte Beanspruchungen, wo eine besonders hohe Tragfähigkeit gefordert wird, Schichten bei denen der Durchmesser der Partikel des eingelagerten Werkstoffes eine statistische Normalverteilung mit einem Mittelwert von $x \le 0,8$ $\mu$m aufweist. Für geringere Beanspruchungen sowie bei Wälzkörpern, die nicht randzonengehärtet sind, haben sich weichere Schichten besser bewährt. Die Ausgestaltung dieses Freiheitsgrades ist dem Fachmann bekannt, optimale Härteverläufe für Randschichten wurden für zahlreiche Wälzkörper veröffentlicht. In einigen Fällen wird sich der Aufwand lohnen, Härtegradienten in der Gleitlagerverkstoffschicht zu erzeugen. Die Methoden hierfür sind dem Fachmann inzwischen im Prinzip bekannt. Er kann die Zusammensetzung variieren, Hartstoffe einlagern (gemäss DE-C-28 53 724) oder zum Beispiel über die Beschichtungstemperatur die mittlere Grösse der eingelagerten Partikel ändern (gemäss EP-A-0 256 226). Anstelle von Härtegradienten kann man auch eine Folge von Schichten mit verschiedenen mechanischen Eigenschaften wählen. Eine von ihnen sollte aber eine nach dem PVD-Verfahren aufgebrachte Gleitlagerverkstoffschicht sein.

Auf die Bedeutung der Wahl der richtigen Schichtstärke ist bereits verwiesen worden. Die Beziehung zwischen optimaler Schichtstärke und Oberflächenrauhigkeit hängt natürlich von der Art der Oberflächenrauhigkeit ab. Bekanntlich benötigt man zur tribologisch relevanten Charakterisierung von Oberflächenmikrogeometrien eine grosse Anzahl von Parametern. Der Praktiker wird sich am letzten Bearbeitungsschritt orientieren, also zum Beispiel zwischen gefrästen, gehobelten und geschliffenen Zahnradflanken unterscheiden, und entsprechend das Verhältnis der Beschichtungsdicke (Schichtstärke) zum $R_z$-Wert im Bereich vom 0,2- bis 4-fachen $R_z$ wählen.

Unter PVD- Verfahren zum Aufbringen der Gleitlagerverkstoffschichten haben sich die thermische Verdampfung, die Kathodenzerstäubung und die Lichtbogenverdampfung besonders bewährt. Die Wahl im Einzelfalle hängt vom Schichtverbund, der Form des Grundkörpers und dem ökonomisch vertretbaren Aufwand ab. Es gibt darüber hinreichend Literatur (vgl. E. Bergmann und J. Vogel: Bauteilbeschichtung nach dem PVD-Verfahren" VDI-Berichte 624, 1986). Die Erfindung kann bei allen Maschinenelementen, die vorwiegend einer Wälzbeanspruchung ausgesetzt werden, Verwendung finden. Besonders erwähnt seien Zahnräder, Laufringe von Kugellagern, Laufflächen von Nadellagern, Verdichterschrauben sowie Wälz- und Drehkolben.

Ausführungsbeispiele der Erfindung werden im folgenden näher erläutert. Dabei zeigt:

Figur 1 einen Querschnitt aus einem Zahnrad dessen Funktionsfläche mit einer Schicht aus Gleitlagerwerkstoff gemäss Erfindung versehen ist.

Figur 2 einen Querschnitt aus einem Kugellagerinnenlaufring, ebenfalls erfindungsgemäss mit einer im PVD-Verfahren aufgebrachten Gleitwerkstoffschicht.

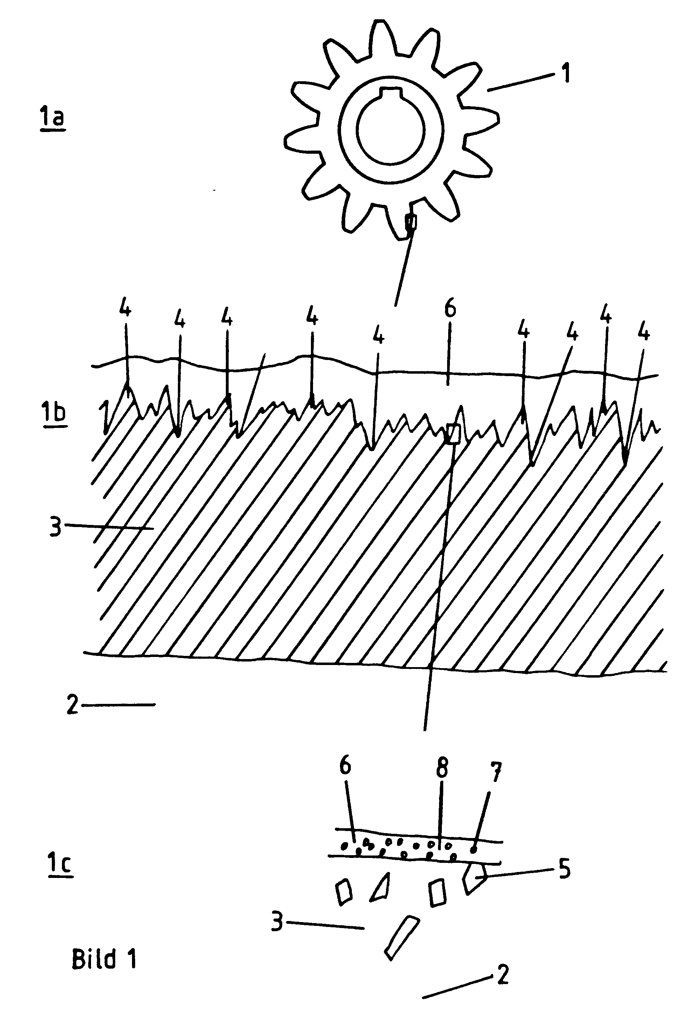

Im Beispiel der Figur 1 wurde ein Zahnrad (Fig 1a) aus einsatzgehärtetem Stahl gefertigt und danach bis zu einer Tiefe von einigen Zehntelmillimetern aufgekohlt und danach nochmals konturgeschliffen. Dies erzeugt auf den Flanken des Zahnrads eine charakteristische Oberflächenrauhigkeit, wie sie in Fig. 1b grob dargestellt ist. Die Stärke der aufgebrachten Schicht wurde (6) so gewählt, dass sie von ähnlicher Grössenordnung wie die grössten Erhebungen (4) des aufgekohlten Grundwerkstoffs ist (2). Ausschnitt 1c zeigt in nochmaliger Vergrösserung den Verbund aus zähem Grundmaterial und (2), der Wälzverschleissrandzone (3) mit den eingelagerten Primärkarbiden (5) und die darüberliegende AlSn20Cu-Schicht (6), mit den feinstverteilten Zinntröpfchen (7) in der Aluminiumlegierungsmatrix (8). Die Herstellung der Schicht kann in einer an sich bekannten Kathodenzerstäubungsvorrichtung durchgeführt werden, in welcher ein ringförmiges, dichtes Plasma mittels eines Magnetfeldes unmittelbar vor der Kathode konzentriert wird. Die im Beispiel benutzte Anlage wies eine zylindrische Prozesskammer auf, an deren Innenseite bis zu maximal vier Quellen von je 322.6 cm$^2$ Fläche vertikal montiert werden konnten. Die zu beschichtenden Substrate werden ebenfalls vertikal auf einem Träger angebracht, der durch einen Drehantrieb rotiert werden konnte, der zwischen 0.2 und 24.5 Umdrehungen pro Minute regelbar war (vgl. beispielsweise BALZERS Produktionformationen BB 800 246 PD/August 1985 sowie BB 800 039 RD/Juli 1985).

Die Arbeitsfläche des in Fig. 1 vorgestellten Zahnrades wurde in einer Zerstäubungsanlage bei einem Druck von 1.2 Pa in Argon in vollständiger Abwesenheit von Sauerstoff während 10 Minuten beschichtet.

Als Targets bei der Zerstäubung wurden 3 Targets aus einer Aluminium/Zinnbronze der Zusammensetzung AlSn20Cu bei einer Spannung von 800 Volt eingesetzt und mit einem Strom von 20 A gefahren. Bei einer Rotation des Zahnrades mit einer konstanten Umdrehungsgeschwindigkeit von 15 Umdrehungen pro Minute wurde dabei eine Beschichtungsgeschwindigkeit von rund 0.6 um/Min. entsprechend einer Schichtdicke von rund 6 um am Ende der Behandlung erreicht.

Die auf diese Weise erzeugt Schicht wies ein Gewichtsverhältnis von Al:Sn:Cu von 80:20:1 (entsprechend der Zusammensetzung AlSn20CuI) und einen Oxidgehalt von weniger als 0.2 Gewichtsprozenten auf. Sie wies mittlere Partikeldurchmesser von rund 0.3 $\mu$m auf und die Härte betrug 113 HV 0.002.

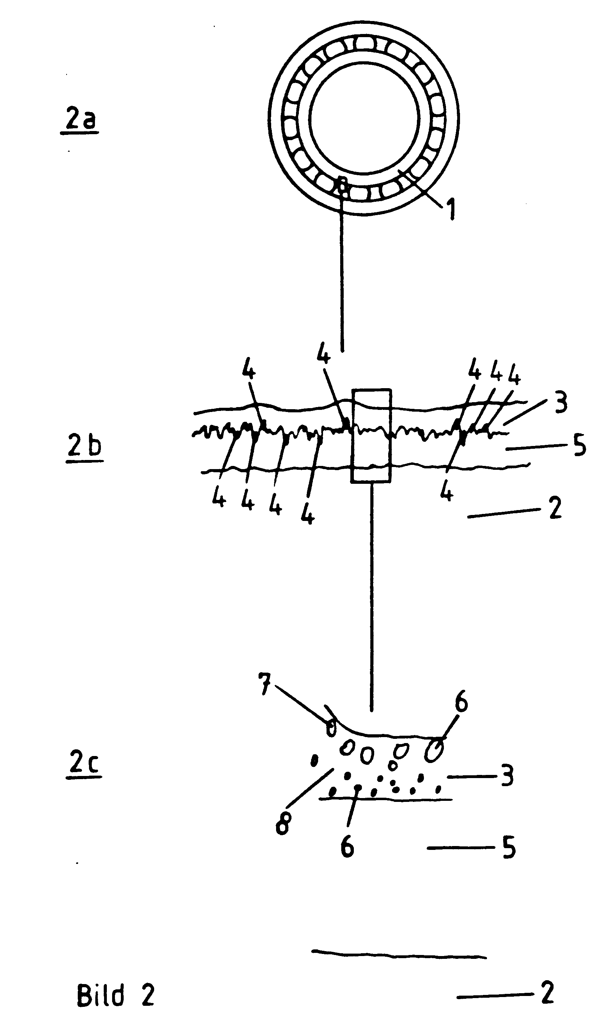

Als weiteres Beispiel zeigt Figur 2 die Ausführungsform eines Kugellagerinnenrings (1) mit einer darauf erfindungsgemäss aufgebrachten Schicht. In diesem Fall wird der Ring mit Diamantpaste spitzenlos fein poliert, was die im Bild 2b gezeigte Oberflächenstruktur mit einer charakteristischen regelmässigen Rauheit (4) ergibt. Weitere Einzelheiten sind aus Figur 2c ersichtlich. Ueber dem Stahlgrundmaterial (2) wurde eine den Wälzverschleisswiderstand weiter erhöhende Hartstoffschicht (5) aufgebracht und darüber eine Schicht aus AlSn10Pb10Cu (3), in der die Partikelgrösse der Zinnausscheidungen (6) wie der Bleiausscheidungen (7) in der Aluminiummatrix (8) zunimmt und so einen Härteabfall zur Oberfläche hin erzeugt.

Bei einem vierten Beispiel handelt es sich um die Lösung eines Verschleissproblems bei einem Kugellager und zwar eines Stirnkugellagers mit 60 mm Laufbahndurchmesser. Es bestand aus 12 Kugeln vom Durchmesser 9,4 mm und einem Käfig aus einer Nickel-Berylliumiegierung und wurde unter folgenden Bedingungen eingesetzt: 700 Umdrehungen pro Minute, 20 kg axiale Last, keine Oelnachführung.

Die Laufringe dieses Kugellagers waren aus 100 Cr6 gefertigt, gehärtet und bei 198° C angelassen. Als letzte Bearbeitung wurden die Laufflächen poliert, und zwar auf eine mittlere Rauhtiefe von 0,2 $\mu$m. Danach wurden die Laufringe nach einem ähnlichen Verfahren wie im Beispiel 1 beschichtet. Als Legierung für die Targets wurde allerdings AlSn10Pb10 verwendet und die Beschichtungsdauer betrug nur 1 Minute. Dies reichte aus, um auf den Kugellagerlaufflächen eine Schicht von 0,3 $\mu$m abzuscheiden. Die Teile wurden während der Beschichtung zusätzlich so beheizt, dass die Temperatur während der Beschichtung von 8° C auf 170° C anstieg. Das Rasterelektronenmikroskop zeigte eine Partikelgrösse von eingelagertem Blei und Zinn, die im Bereich der Stahloberfläche kleiner als 0,05 $\mu$m war, während im oberflächennahen Bereich eine deutliche Segregation sichtbar war. Aus Vergleichsmessungen an Probekörpern wissen wir, dass die Härte der Schicht in der Nähe der Stahloberfläche im Bereich von 140 HV liegen musste, um dann im oberflächennahen Bereich auf 30 HV abzusinken. Während unbeschichtete Kugellager im Test schon nach 20 Minuten starken Verschleiss zeigten, der sich in Lärm und starken Vibrationen äusserte, liefen beschichtete Kugellager ohne Zunahme des Geräuschpegels während 24 Stunden.

Ein fünftes Beispiel betrifft das Problem, wie die unerträgliche Lärmentwicklung von PKw-Getrieben bei hohen Drehzahlen gemildert werden könnte. In einem vorgegebenen Getriebe betrug bei starker Belastung im 4. Gang die Schallemmission 18 Dezibel. Das Getriebe war aus einsatzgehärtetem 16Mn Cr5 gefertigt. Die Verzahnung war gefräst und wies auf den Flanken eine Oberflächerauhigkeit mit einem $R_z$ von 10 $\mu$m auf. Eine Beschichtung mit Kathodenzerstäubung kam aus wirtschaftlichen Gründen nicht in Frage. Daher wurde ein Ionenplattierverfahren wie es zum Beispiel in der im CH-Patent 64 51 37 beschrieben ist, aber mit zwei Elektronenstrahlverdampfern, gewählt. Auf die Zahnflanken der Räder wurde eine Schicht von 18 $\mu$m aufgetragen. Die Verdampferleistung im Tiegel mit Zinn wurde im Verhältnis zum Tiegel mit Aluminium so gewählt, dass sich auf den Teilen, die sich auf einem Karussel befanden, eine Beschichtung mit einem Massenverhältnis von Aluminium zu Zinn von etwa 4 : 1 einstellt. Im übrigen entsprachen die Charakteristiken der Schicht dem Beispiel 1, nur konnte aufgrund der höheren Plasmadichte eine Temperatur von 120° C zugelassen werden. Bei einem Getriebe vom fraglichen Typ, bei dem nur das Antriebsrad des 4. Ganges beschichtet war, konnte ein Absenken des Lärmpegels auf 16 Dezibel erzielt werden.

Bei einem sechsten Beispiel handelt es sich wieder um ein Kugellagerverschleissproblem, das bei einem Hochgeschwindigkeitskugellager auftrat, das in den Steuerkreisen von Flugkörpern Verwendung

findet. Um den Verschleiss zu vermeiden, verwendet man in diesen Kugellagern Kugeln aus Hartmetall, und zwar einer Wolframkarbid-/Kobaltlegierung, die im allgemeinen keinem Verschleiss unterliegen. Auch der Verschleiss der Laufflächen ist im allgemeinen im Bereich der Toleranz. Bei 1% der Lager traten allerdings im Einsatz vorzeitiger Ausfall ein. Eine Schadensanalyse ergab, dass dies auf Gleitverschleiss zurückzuführen ist, dessen Ursache in starken Beschleunigungen liegt. Die Kugeln dieser Lager wiesen eine Oberflächenrauheit $R_z$ von 0,02 $\mu$m auf. Sie wurden ähnlich dem Beispiel 1 beschichtet, nur wurde die Anlage mit zwei Kupfer-, einem Blei- und einem Zinntarget bestückt. Die Kugeln wurden nicht gekühlt. Nach drei Minuten hatte sich auf ihnen eine Schicht von 0,06 $\mu$m gebildet, die in der Zusammensetzung CuZn20Pb10 entsprachen. Eine Untersuchung im Transmissionselektronenmikroskop zeigte, dass die Schicht aus sehr feinen eingelagerten Blei-/Zinnpartikeln und einer Messingmatrix bestand. Kugellager, die mit so beschichteten Kugeln ausgerüstet waren, zeigten keinerlei Ausfälle.

Das nachfolgende siebente Beispiel zeigt, wie mit dem erfindungsgemässen Verbundwerkstoff das Problem einer Wälzkolbenpumpe, die ungeölt betrieben werden muss, um reine Gase fördern zu können, gelöst werden kann. In diesen Pumpen trat an den Rollflächen der Kolben sehr rasch Verschleiss auf, der zum Fressen führte. Um dieses Problem zu beheben, wurde folgende Lösung gewählt:

Die Laufflächen der Kolben wurden nach einem handelsüblichen Verfahren chemisch vernickelt, und zwar mit einer Schichtstärke von 16 $\mu$m. Nach dieser Vernickelung, die nur eine leichte Verbesserung, aber keine Lösung des Problems gebracht hatte, wiesen die Laufflächen eine Oberflächenrauheit mit $R_z = 2$ $\mu$m mit der für chemischen Nickel charakteristischen Buckelstruktur auf. Als Beschichtungsverfahren wurde wieder die Kathodenzerstäubung gewählt, wobei ähnlich vorgegangen wurde wie im Beispiel 1. Nur wurden bei dieser Anwendung zwei Targets aus Aluminium und zwei Targets aus Zinn gewählt. Die Entladungsströme auf den Targets wurden während der Beschichtung kontinuierlich geändert, und zwar wie folgt:

| Zeit | Gesamtentladungsstrom Aluminiumtargets | Gesamtentladungsstrom Zinntargets |
|---|---|---|
| 0 - 5 Min. | 40 A | 0 |
| 5- 40 Min. | 40 A | von 0 auf 30 A steigend |

Die danach vorgefundene Schichtstärke betrug 6 $\mu$m. Die Temperatur der Teile wurde durch Kühlung auf unter 50° C gehalten, so dass wieder eine Feinverteilung von Zinntröpfchen in einer Aluminiummatrix beobachtet werden konnte. Nur nahm die Dichte der Zinnpartikel zur Oberfläche hin zu. Auch der mittlere Durchmesser stieg etwas an, und zwar von 0,4 $\mu$m auf 0,9 $\mu$m. Wälzkolbenpumpen, mit so behandelten Funktionsflächen, konnten über längere Zeit ohne Fressprobleme betrieben werden.

In einem achten Beispiel handelt es sich um das Problem des Verschleisses der Welle am Fahrrad. Die Aufhängung des Vorderrades ist in diesem Falle so ausgebildet, dass auf der fest von der Gabel gehaltenen Welle die Kugeln laufen. Der Aussenring dieser Kugellagerung bildet die Nabe des Fahrrades. Diese Aufhängung wird oft unter starker Neigung belastet, was zu einem Auslenken der Kugeln aus der zentralen Laufspur führt und eine überlagerte Gleitbewegung unter hoher Hertz'scher Pressung bewirkt, die die Tragfähigkeit des Fetts übersteigt. Es kommt zur Mischreibung und in der Folge zu sichtbarem Adhäsivverschleiss auf der Welle. Beim Modell, dessen Problem mit der Beschichtung gelöst wurde, waren diese Wellen aus gedrehtem 100 Cr6 gehärtet und bei 180° C angelassen. Das Drehen hinterläst eine leichte Rietung die auf der erzeugenden des Zylinders eine Oberflächenrauheit von $R_z = 6$ $\mu$m entspricht, während man auf dem Umfang eines Ra von 0.6 $\mu$m misst. Diese Wellen wurden nun allseitig nach dem Kathodenzerstäubungsverfahren mit einer 1.2 $\mu$m starken Schicht folgender Zusammensetzung beschichtet: Kupfer 73%, Blei 23%, Zinn 4%.

Es handelt sich um Gewichtsprozente. Die Substrattemperatur wurde bei dieser Beschichtung nicht kontrolliert. Sie mag im Bereich von 60° - 120° C gelegen haben. Die Schichten wurden im optischen Mikroskop bei 200-facher Vergrösserung kontrolliert, und es wurden keinerlei Bleiausscheidungen festgestellt, wie sie sonst für diesen Werkstoff in gesinterter oder gegossener Form charakteristisch sind. Im Einsatz zeigte sich, dass bei so beschichteten Wellen der Rollreibungskoeffizient auch nach 2000 Km keine Zunahme zeigte.

Schliesslich zeigt ein neuntes Beispiel die Lösung des Problems des Verschleisses der Rotoren von Schraubenverdichtern, sogenannte Verdichterschrauben. Bei diesen Verdichtern gibt es zwei verschiedene Typen, synchronisierte, sowie getriebene. Bei vollsynchronisierten Schrauben tritt eine beinahe reine Wälzbewegung auf. Bei getriebenen wird eine Gleitbewegung so vorgesehen, dass durch dieses Gleiten mit der entsprechenden Reibung die für den Antrieb notwendige Kraftübertragung stattfinden soll. Der Vorteil dieses Systems sind die niedrigern Kosten; der Nachteil: der mit der Reibung verknüpfte Verschleiss im Schlupfbereich der Flanken. Die beiden Rotoren eines derartigen Verdichters wurden aus 100 Cr6 gefertigt. Im Trockenlauf, der zur Verdichtung reiner Gase notwendig ist, ergab sich unbeschichtet eine Lebensdauer von 16 Stunden. Die Oberflächen dieser Rotoren wurden konturgeschliffen, sodass sich eine Oberflächenrauheit von $R_z$ = 0,8 $\mu$m ergeben hatte. Als Beschichtungsverfahren wurde die Kathodenzerstäubung gewählt. Der Aufbau der Anlage und Vorrichtungen ist bereits beschrieben worden (Dr. E.Bergmann, Dr. J. Vogel; J. Vac. Sc. Techn. A5 (1987) Seite 70).

Als Kathodenmaterial wurde eine Aluminiumbronze der folgenden Zusammensetzung in Gewichtsprozenten verwendet: Aluminium 78.8%, Zinn 20%, Silizium 1.2%.

Die Beschichtungsbedingungen waren wie folgt: Anlagendruck 1.2 Pa, Stäubleistung 4 x 18 kW, Sauerstoffpartialdruck 0.06 Pa.

Durch das Hinzufügen des Sauerstoffes ergab sich eine Verdoppelung der Härte auf $HV_{0.01}$ = 300. Die so beschichteten Verdichterschrauben zeigten unter denselben Bedingungen wie die unbeschichteten eine Lebensdauer von 40 Stunden.

## Patentansprüche

1. Bauteil, insbesondere Maschinenelement, das vorwiegend einer Wälzbeanspruchung, aber auch einer Gleitbeanspruchung ausgesetzt ist, bestehend aus einem Grundkörper, auf dessen der Wälzbeanspruchung auszusetzenden Teilen der Oberfläche eine ein- oder mehrschichtige Beschichtung aus Gleitlagerwerkstoff aufgetragen ist, dadurch gekennzeichnet, dass eine mit einem PVD-Verfahren hergestellte Beschichtung aus Gleitlager-Legierungswerkstoff mit einer Dicke vom 0,2- bis 4-fachen der Oberflächenrauheit $R_z$ des Grundkörpers aufgetragen ist.

2. Bauteil nach Anspruch 1,
dadurch gekennzeichnet, dass die Gleitlagerwerkstoff-Beschichtung aus wenigstens zwei Phasen besteht, wovon eine eine fest zusammengefügte Matrix bildet und die andere aus einem eingelagerten Werkstoff besteht, dessen Schmelzpunkt tiefer liegt als die Temperatur, bei der eine wesentliche Veränderung der mechanischen Eigenschaften des Grundkörpers eintritt.

3. Bauteil nach Anspruch 2,
dadurch gekennzeichnet, dass der Grundkörper aus Stahl besteht und der Schmelzpunkt des eingelagerten Werkstoffes unter der Anlasstemperatur des Stahls des Grundkörpers liegt.

4. Bauteil nach Anspruch 2,
dadurch gekennzeichnet, dass der Grundkörper aus Stahl besteht und eine oberflächengehärtete Randzone aufweist, und dass der Schmelzpunkt des eingelagerten Werkstoffes unter der Anlasstemperatur der oberflächengehärteten Randzone des Grundkörpers liegt.

5. Bauteil nach Anspruch 2,
dadurch gekennzeichnet, dass
a) die Matrix eine Legierung enthält, deren Hauptbestandteil eines der folgenden Elemente ist: Aluminium, Chrom, Nickel, Magnesium, Kupfer,
b) der Hauptbestandteil des eingelagerten Werkstoffes mindestens eines der folgenden Elemente enthält: Zinn, Blei, Indium, Zink.

6. Bauteil nach Anspruch 5,
dadurch gekennzeichnet, dass die Gleitlagerwerkstoff-Beschichtung eine Legierung mit einer der folgenden Zusammensetzungen enthält:
Al Cu Sn, Al Cu Pb, Al Cu Sn Pb,
Al Si Sn, Al Si Pb, Al Si Sn Pb,
Cu Sn, Cu Pb, Cu Sn Pb

**7.** Bauteil nach Anspruch 1,
dadurch gekennzeichnet, dass die Gleitlagerwerkstoff-Beschichtung aus wenigstens zwei Phasen besteht, wovon eine eine Matrix bildet und die andere aus einem eingelagerten Werkstoff besteht, und dass der Durchmesser X der Partikel des eingelagerten Werkstoffes eine statistische Normalverteilung mit einem Mittelwert von x ≤ 0,8 $\mu$m aufweist.

**8.** Bauteil nach Anspruch 7,
dadurch gekennzeichnet, dass der Mittelwert der Durchmesser der Partikel des eingelagerten Werkstoffes so gewählt wird, dass die Härte der Gleitlagerwerkstoffbeschichtung dem des Grundwerkstoffes optimal angepasst ist.

**9.** Bauteil nach Anspruch 8,
dadurch gekennzeichnet, dass die Gleitlagerwerkstoffbeschichtung einen Gradienten des Härteverlaufs normal zur Oberfläche aufweist, der mit einer der folgenden Methoden erzielt wurde:
a) Veränderung der Verhältnisse der Legierungselemente,
b) Veränderung des mittleren Partikeldurchmessers des eingelagerten Werkstoffes,
c) Einlagerung von Oxiden, Karbiden, Boriden oder Siliziden des Matrixwerkstoffes mit verschiedener Konzentration.

**10.** Bauteil nach Anspruch 1,
dadurch gekennzeichnet, dass die Gleitlagerwerkstoff-Beschichtung aus mehreren Gleitlagerwerkstoffschichten besteht.

**11.** Bauteil nach einem der Ansprüche 1 bis 10,
dadurch gekennzeichnet, dass die Gleitlagerwerkstoffbeschichtung eine Dicke von 0,5 bis 15 $\mu$m aufweist.

**12.** Bauteil nach Anspruch 1,
dadurch gekennzeichnet, dass es als Zahnrad ausgebildet ist.

**13.** Bauteil nach Anspruch 1,
dadurch gekennzeichnet, dass es als Wälzlager ausgebildet ist.

**14.** Bauteil nach Anspruch 1,
dadurch gekennzeichnet, dass es als Welle ausgebildet ist.

**15.** Bauteil nach Anspruch 1,
dadurch gekennzeichnet, dass es als Verdichterschraube ausgebildet ist.

**16.** Bauteil nach einem der Ansprüche 1 bis 11,
dadurch gekennzeichnet, dass es als Wälzkolben ausgebildet ist.

**17.** Bauteil nach einem der Ansprüche 1 bis 11, dadurch gekennzeichnet, dass es als Drehkolben ausgebildet ist.

**Claims**

**1.** A component, in particular a machine element, which is predominantly subjected to a rolling loading but also a sliding loading, comprising a base body, to the parts of the surface of which, that are to be subjected to the rolling loading, there is applied a single-layer or multi-layer coating of sliding bearing material, characterised in that a coating which is produced by a a PVD-process and comprising sliding bearing alloy material is applied, of a thickness of from 0.2 to 4 times the surface roughness R of the base body.

**2.** A component according to claim 1 characterised in that the sliding bearing material coating comprises at least two phases of which one forms a fixedly united matrix and the other comprises an incorporated material whose melting point is lower than the temperature at which there is a substantial change in the mechanical properties of the base body.

7

**3.** A component according to claim 2 characterised in that the base body comprises steel and the melting point of the incorporated material is below the annealing temperature of the steel of the base body.

**4.** A component according to claim 2 characterised in that the base body comprises steel and has a surface-hardened edge zone, and that the melting point of the incorporated material is below the annealing temperature of the surface-hardened edge zone of the base body.

**5.** A component according to claim 2 characterised in that
a) the matrix contains an alloy whose main component is one of the following elements: aluminium, chromium, nickel, magnesium or copper,
b) the main component of the incorporated material contains at least one of the following elements: tin, lead, indium and zinc.

**6.** A component according to claim 5 characterised in that the sliding bearing material coating contains an alloy of one of the following compositions:
Al Cu Sn, Al Cu Pb, Al Cu Sn Pb,
Al Si Sn, Al Si Pb, Al Si Sn Pb,
Cu Sn, Cu Pb, Cu Sn Pb.

**7.** A component according to claim 1 characterised in that the sliding bearing material coating comprises at least two phases of which one forms a matrix and the other comprises an incorporated material, and that the diameter X of the particles of the incorporated material has a statistical normal distribution with a mean value of $x \leq 0.8 \mu$m.

**8.** A component according to claim 7 characterised in that the mean value of the diameters of the particles of the incorporated material is so selected that the hardness of the sliding bearing material coating is adapted in optimum fashion to that of the base material.

**9.** A component according to claim 8 characterised in that the sliding bearing material coating has a gradient in respect of the hardness distribution normal to the surface, which was achieved with one of the following methods:
a) variation in the ratios of the alloy elements,
b) variation in the mean particle diameter of the incorporated material, and
c) incorporation of oxides, carbides, borides or silicides of the matrix material with a different level of concentration.

**10.** A component according to claim 1 characterised in that the sliding bearing material coating comprises a plurality of sliding bearing material layers.

**11.** A component according to one of claims 1 to 10 characterised in that the sliding bearing material coating is of a thickness of from 0.5 to 15 $\mu$m.

**12.** A component according to claim 1 characterised in that it is in the form of a gear wheel.

**13.** A component according to claim 1 characterised in that it is in the form of a rolling bearing.

**14.** A component according to claim 1 characterised in that it is in the form of a shaft.

**15.** A component according to claim 1 characterised in that it is in the form of a compressor screw.

**16.** A component according to one of claims 1 to 11 characterised in that it is in the form of a nutating piston.

**17.** A component according to one of claims 1 to 11 characterised in that it is in the form of a rotary piston.

**Revendications**

**1.** Elément de construction, en particulier organe de machine, exposé principalement à une contrainte de roulement, mais également à une contrainte de glissement, qui se compose d'un corps de base dont les parties de la surface devant être exposées à la contrainte de roulement sont recouvertes d'un revêtement en une ou plusieurs couches fait d'un matériau pour palier lisse, caractérisé en ce qu'un revêtement en matériau d'alliage pour palier lisse obtenu par un procédé de dépôt physique en phase vapeur est déposé suivant une épaisseur de 0,2 à 4 fois la rugosité de surface RZ du corps de base.

2.  Elément de construction selon la revendication 1, caractérisé en ce que le revêtement en matériau pour palier lisse se compose d'au moins deux phases dont l'une d'elles constitue une matrice à forte cohésion et dont l'autre consiste en un matériau incorporé dont le point de fusion est situé à un niveau plus bas que la température à laquelle se produit une modification sensible des propriétés mécaniques du corps de base.

3.  Elément de construction selon la revendication 2, caractérisé en ce que le corps de base se compose d'acier et en ce que le point de fusion du matériau incorporé se situe au-dessous de la température de revenu de l'acier du corps de base.

4.  Elément de construction selon la revendication 2, caractérisé en ce que le corps de base se compose d'acier et présente une zone marginale trempée superficiellement, et en ce que le point de fusion du matériau incorporé se situe au-dessous de la température de revenu de la zone marginale trempée superficiellement du corps de base.

5.  Elément de construction selon la revendication 2, caractérisé en ce que :
    a) la matrice contient un alliage dont le constituant principal est l'un des éléments suivants : aluminium, chrome, nickel, magnésium, cuivre,
    b) le constituant principal du matériau incorporé contient au moins l'un des éléments suivants : étain, plomb, indium, zinc.

6.  Elément de construction selon la revendication 5, caractérisé en ce que le revêtement en matériau pour palier lisse contient un alliage ayant l'une des compositions suivantes :
    Al Cu Sn, Al Cu Pb, Al Cu Sn Pb,
    Al Si Sn, Al Si Pb, Al Si Sn Pb,
    Cu Sn, Cu Pb, Cu Sn Pb

7.  Elément de construction selon la revendication 1, caractérisé en ce que le revêtement en matériau pour palier lisse se compose d'au moins deux phases dont l'une d'elles constitue une matrice et dont l'autre consiste en un matériau incorporé, et en ce que le diamètre X des particules du matériau incorporé présente une distribution statistique de Gauss ayant une valeur moyenne de x ≤ 0,8 $\mu$m.

8.  Elément de construction selon la revendication 7, caractérisé en ce que la valeur moyenne du diamètre des particules du matériau incorporé est choisie de telle sorte que la dureté du revêtement en matériau pour palier lisse soit adaptée de manière optimale à la valeur moyenne du diamètre des particules du matériau de base.

9.  Elément de construction selon la revendication 8, caractérisé en ce que le revêtement en matériau pour palier lisse présente un gradient de variation de la dureté, perpendiculairement à la surface, qui a été obtenu avec l'un des procédés suivants :
    a) modification des rapports des éléments d'alliage,
    b) modification du diamètre moyen des particules du matériau incorporé,
    c) incorporation d'oxydes, carbures, borures ou siliciures dans le matériau de la matrice, avec une concentration différente.

10. Elément de construction selon la revendication 1, caractérisé en ce que le revêtement en matériau pour palier lisse se compose de plusieurs couches de matériau pour palier lisse.

11. Elément de construction selon l'une quelconque des revendications 1 à 10, caractérisé en ce que le revêtement en matériau pour palier lisse présente une épaisseur de 0,5 à 15 $\mu$m.

12. Elément de construction selon la revendication 1, caractérisé en ce qu'il se présente sous la forme

9

d'une roue dentée.

**13.** Elément de construction selon la revendication 1, caractérisé en ce qu'il se présente sous la forme d'un palier de roulement.

**14.** Elément de construction selon la revendication 1, caractérisé en ce qu'il se présente sous la forme d'un arbre.

**15.** Elément de construction selon la revendication 1, caractérisé en ce qu'il se présente sous la forme d'une vis de compresseur.

**16.** Elément de construction selon l'une quelconque des revendications 1 à 11, caractérisé en ce qu'il se présente sous la forme d'un piston coulissant.

**17.** Elément de construction selon l'une quelconque des revendications 1 à 11, caractérisé en ce qu'il se présente sous la forme d'un piston rotatif.

1a

1

1b

4   4   4   4   4   6   4   4   4   4

3

2

1c

6   8   7

5

3

2

Bild 1

2a

2b

2c

Bild 2

2